# EUROPEAN PATENT APPLICATION

(11) **EP 4 145 701 A1**
(43) Date of publication of application: **08.03.2023**
(21) Application number: 21797830.3
(22) Date of filing: 28.04.2021
(51) Int. Cl.: H03H 9/02, H03H 9/00, H03H 3/007

(54) **FILTER AND MANUFACTURING METHOD FOR SAME**

(30) Priority: 29.04.2020 KR 20200052843; 27.04.2021 KR 20210054539
(71) Applicant: KMW Inc., Hwaseong-si, Gyeonggi-do 18462 (KR)
(72) Inventor: PARK, Nam Shin, Hwaseong-si Gyeonggi-do 18454 (KR); JANG, Sung Ho, Yongin-si Gyeonggi-do 16978 (KR); LEE, Kwang Il, Yongin-si Gyeonggi-do 17086 (KR); KO, Kyoung Hun, Hwaseong-si Gyeonggi-do 18498 (KR); KIM, Joung Hoe, Hwaseong-si Gyeonggi-do 18497 (KR); PARK, Yong Jin, Hwaseong-si Gyeonggi-do 18418 (KR)
(74) Representative: Scheele Jaeger Wetzel Patentanwälte
(86) International application number: PCT/KR2021/005344
(87) International publication number: WO 2021/221449

(57) **Abstract**

The present invention relates to a filter and a method of manufacturing the same, the filter including an RF connector configured to have a predetermined electrical signal line, a filter body having at least one impedance matching space in which the RF connector is installed, a relevant PCB on which one end of the RF connector is fixedly mounted, the relevant PCB coupled to be in close contact with one side surface of the filter body, and an annular gasket interposed between one side surface of the filter body and the relevant PCB to block a signal leak, in which a concave-convex portion is processed on a surface of one side surface of the filter body to which the annular gasket is attached to increase an attachment area, thereby providing an advantage of improving a bonding force of an attachment portion to which the gasket is attached.

## Description

### [Technical Field]

The present invention relates to a filter and a method of manufacturing the same, and more particularly, to a filter and a method of manufacturing the same that increase a tensile force of a gasket and a coating surface and decrease manufacturing costs.

### [Background Art]

In general, a gasket of a filter is used as a means for blocking a signal. An entire housing, which constitutes the filter, is plated with trivalent chromate, and then the gasket is applied along a window to join the gasket. In this case, the trivalent chromate plating serves to increase a tensile force of the gasket bonded to an outer surface of a filter body. In general, the gasket is made of rubber. Therefore, the configuration in which the gasket made of rubber is applied onto the outer surface of the filter plated with trivalent chromate generates a higher tensile force than the configuration in which the gasket is applied directly to the outer surface of the filter made of a material different from rubber.

However, the configuration in which the entire housing, which constitutes the filter, is plated with trivalent chromate is not preferred in terms of environment, costs, and manufacturing.

In addition, a configuration in which only a portion of the outer surface of the filter, which is coated with the gasket, is plated with trivalent chromate may be considered. However, in this case, there is a problem in that a bonding force between the filter and the trivalent chromate plating is decreased.

### [Disclosure]

### [Technical Problem]

The present invention has been made in an effort to solve the above-mentioned problem, and an object of the present invention is to provide a filter manufactured by eliminating a trivalent chromate plating process and by performing surface processing only on a local portion to which a gasket is joined to directly increase a physical tensile force between the gasket and a filter or by performing the surface processing after performing a silver plating process only on a local portion to which the gasket is joined, instead of the trivalent chromate plating process in the related art, and a method of manufacturing the same.

### [Technical Solution]

One embodiment of the present invention provides a filter including: an RF connector configured to have a predetermined electrical signal line; a filter body having at least one impedance matching space in which the RF connector is installed; a relevant PCB (Printed circuit board) on which one end of the RF connector is fixedly mounted, the relevant PCB coupled to be in close contact with one side surface of the filter body; and an annular gasket interposed between one side surface of the filter body and the relevant PCB to block a signal leak, in which a concave-convex portion is processed on a surface of one side surface of the filter body to which the annular gasket is attached to increase an attachment area.

In this case, the gasket may be made of rubber.

In addition, the concave-convex portion may be processed and formed by a laser processing machine.

In addition, the concave-convex portion may be processed and formed by a stamping tool.

In addition, the concave-convex portion may be formed on a surface of a silver plating layer formed on one side surface of the filter body by plating.

Another embodiment of the present invention provides a method of manufacturing a filter, the method including: a concave-convex portion forming process of processing and forming a concave-convex portion on one side surface of a filter body to which an annular gasket is attached between the filter body and a relevant PCB coupled to be in close contact with one side of the filter body; and a dispensing process of dispensing and applying resin, which is a molding material for the gasket, on one side surface of the filter body after the concave-convex portion forming process.

In this case, the concave-convex portion forming process may be a process of forming the annular concave-convex portion on an outer rim portion of an impedance matching space penetratively formed in the filter body toward one side surface.

In addition, the concave-convex portion forming process may be a process of processing and forming the concave-convex portion by a laser processing machine.

In addition, the concave-convex portion forming process may be a process of processing and forming the concave-convex portion by a stamping tool.

In addition, the method may further include: a silver plating process of plating one side surface of the filter body, on which the concave-convex portion is formed, with silver before the concave-convex portion forming process.

In addition, the method may further include: the dispensing process of dispensing and applying the resin, which is the molding material for the gasket, on one side surface of the filter body after the concave-convex portion forming process.

In addition, resin, which is a molding material for the gasket applied by the dispensing process, may penetrate into a concave portion of the concave-convex portion, and after the resin is cured, the resin may have a viscosity to a degree to which the resin has a predetermined thickness from one side surface of the filter body on which the concave-convex portion is formed.

In addition, an application thickness of the gasket during the dispensing process may be set to be larger than a thickness of the concave-convex portion.

### [Advantageous Effects]

According to the filter and the method of manufacturing the same according to the embodiment of the present invention, the process of applying trivalent chromate may be eliminated, which makes it possible to prevent environmental pollution, reduce manufacturing costs, and further increase a physical bonding force between the gasket and the upper surface of the filter.

### [Description of Drawings]

FIG. 1 is a cross-sectional view illustrating an embodiment of a filter according to the present invention.
FIG. 2 is a part of a top plan view and a part of a cross-sectional view illustrating concave-convex portions among components in FIG. 1.
FIG. 3 is a partially enlarged view of FIG. 1 and a cross-sectional view illustrating a method of manufacturing a filter according to a first embodiment.
FIG. 4 is a partially enlarged view of FIG. 1 and a cross-sectional view illustrating a method of manufacturing a filter according to a second embodiment.
FIG. 5 is a flowchart illustrating a sequence of the method of manufacturing a filter according to the embodiment of the present invention.
FIGS. 6 and 7 are views illustrating samples manufactured by a laser processing machine and a stamping tool.

### <Explanation of Reference Numerals and Symbols>

- 10:: Filter body
- 20:: Impedance matching space
- 30:: RF connector
- 40:: Relevant PCB
- 50:: Gasket
- 60:: Resonance bar
- 70:: Concave-convex portion
- 71:: Concave portion
- 72:: Convex portion
- 110:: Laser processing machine
- 120:: Stamping tool
- S10:: Silver plating process
- S20:: Concave-convex portion forming process
- S30:: Dispensing process

### [Best Mode]

Hereinafter, embodiments of a filter and a method of manufacturing the same according to the present invention will be described in detail with reference to the accompanying drawings.

In giving reference numerals to constituent elements of the respective drawings, it should be noted that the same constituent elements will be designated by the same reference numerals, if possible, even though the constituent elements are illustrated in different drawings. Further, in the following description of the embodiments of the present invention, a detailed description of related publicly-known configurations or functions will be omitted when it is determined that the detailed description obscures the understanding of the embodiments of the present invention.

In addition, the terms first, second, A, B, (a), and (b) may be used to describe constituent elements of the embodiments of the present invention. These terms are used only for the purpose of discriminating one constituent element from another constituent element, and the nature, the sequences, or the orders of the constituent elements are not limited by the terms. Further, unless otherwise defined, all terms used herein, including technical or scientific terms, have the same meaning as commonly understood by those skilled in the art to which the present invention pertains. The terms such as those defined in commonly used dictionaries should be interpreted as having meanings consistent with meanings in the context of related technologies and should not be interpreted as ideal or excessively formal meanings unless explicitly defined in the present application.

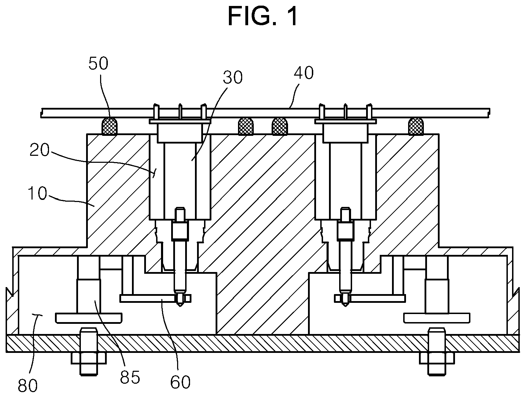

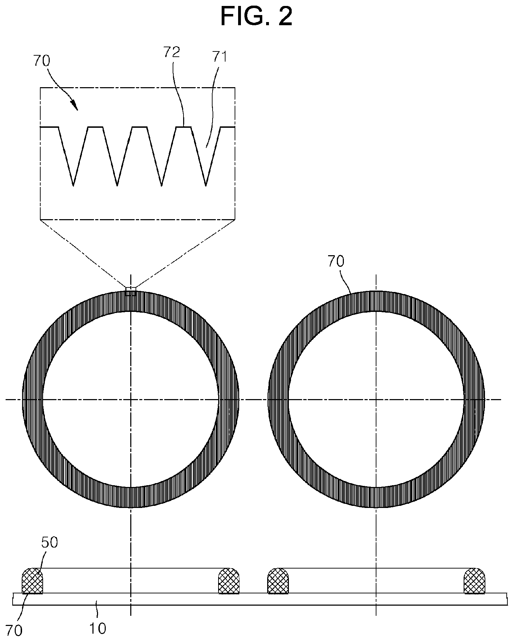

FIG. 1 is a cross-sectional view illustrating an embodiment of a filter according to the present invention, and FIG. 2 is a part of a top plan view and a part of a cross-sectional view illustrating concave-convex portions among components in FIG. 1.

As illustrated in FIG. 1, an embodiment of a filter according to the present invention includes: an RF connector 30 configured to have a predetermined electrical signal line; a filter body 10 having at least one impedance matching space 20 in which the RF connector 30 is installed; a relevant PCB 40 fixedly mounted at one end of the RF connector 30 and coupled to be in close contact with one side surface of the filter body 10; and an annular gasket 50 interposed between one side surface of the filter body 10 and the relevant PCB 40 to block a signal leak.

The filter body 10 may have one surface opened so that one end of the RF connector 30 is exposed and connected to the relevant PCB 40.

In this case, a resonance bar 60 having a bar shape may be provided in the filter body 10 and connected to the other end of the RF connector 30. The resonance bar 60 may be connected to a resonance rod 85 installed in a plurality of cavities 80 of a cavity filter.

As described above, the RF connector 30 is positioned in the filter body 10 that defines the impedance matching space 20. A portion between one end and the other end of the RF connector 30 is extended or contracted by an assembling force applied during an assembling process. One end of the RF connector 30 is connected to the relevant PCB 40 by being mounted on or in contact with the relevant PCB 40. The other end of the RF connector 30 is connected to the resonance rod 85 by being mounted on or in contact with the resonance rod 85. Therefore, the RF connector 30 may be configured as a direct coaxial connector that electrically connects stacks of a plurality of filter layers and PCB layers.

The impedance matching space 20 defined in the filter body 10 may be a space designed to match impedance when the signal is transmitted through the predetermined electrical signal line established by means of the RF connector 30.

Meanwhile, the gasket 50 may serve to prevent a signal leak through a space between the relevant PCB 40 and an outer portion of the filter body 10 that is an opening portion of the impedance matching space 20. In case that a physical gap is formed in the space between the relevant PCB 40 and the outer portion of the filter body 10, there is concern that the signal matched in the impedance matching space 20 leaks, and the impedance matching is broken. Therefore, the gasket 50 is interposed between the relevant PCB 40 and the filter body 10.

In this case, the gasket 50 may be made of rubber. More specifically, the gasket 50 may be a molding material made of rubber and attached to one side surface of the filter body 10 while protruding by being applied by a dispensing process and cured. When the relevant PCB 40 comes into close contact with the gasket 50 in the case in which the gasket 50 is applied by the dispensing process and cured, the gasket 50 made of rubber may be elastically deformed and completely block the gap between the relevant PCB 40 and the opened outer surface of the filter body 10.

Further, the gasket 50 may have an annular shape and be disposed to surround a rim portion of the opening portion of the impedance matching space 20 of the filter body 10.

In the related art, to couple the gasket 50 to the filter body 10 while maintaining a predetermined bonding force of the gasket 50, a separation process is performed after a masking process is performed on one side surface of the filter body 10 to which the gasket 50 is bonded, a trivalent chromate plating process is performed on an entire surface of an outer portion of a housing that constitutes the filter body 10, and then the gasket 50 is bonded by a dispensing process. For this reason, there is a problem in that cracks occur because of a high temperature during the chromate separation process and the plating process, and there occurs a problem with a close-contact force during the dispensing process. In addition, in the related art, a problem of environmental pollution subsidiarily occurs because the trivalent chromate plating process is essentially performed.

However, the embodiments of the filter and the method of manufacturing the same according to the present invention propose an innovative technical configuration capable of completely eliminating the chromate plating process by completely correcting the method of attaching the gasket 50 by using trivalent chromate plating in the related art.

More specifically, as illustrated in FIG. 2, a concave-convex portion 70 may be processed and formed on a surface of one side surface of the filter body 10, to which the annular gasket 50 is attached, to increase an attachment area.

In this case, referring further to the enlarged view in FIG. 2, the concave-convex portion 70 is formed by repeatedly forming concave portions 71 and convex portions 72 and further increases an area of an attachment surface to which the gasket 50 is attached and maintains a predetermined attachment force in comparison with a case in which the attachment surface is flat.

More specifically, in the concave-convex portion 70, fine trough shapes constituting the concave portions 71 and fine crest shapes constituting the convex portions 72 are repeatedly arranged and formed in straight shapes parallel to one another in the same direction and intersect one another so that the concave portions 71 and the convex portions 72 define a lattice pattern, such that a large number of fine concave-convex portions 70 may be formed.

However, one side surface of the filter body 10 may be plated with silver before the concave-convex portion 70 is processed and formed by a laser processing machine 110 or a stamping tool 120 to be described below. In this case, the silver plating need not be performed on the entire outer surface of the filter body 10, but the silver plating may be performed only on one side surface of the filter body 10 onto which the gasket 50 is applied. Because the concave-convex portion 70 is formed on the outer surface of the filter body 10 plated with silver, a silver plating layer may be defined as a portion processed and formed by using the laser processing machine 110 or the stamping tool 120, as described below.

Because of the characteristics of silver, the silver material is harmless to a human body and reduces a risk of environmental pollution. The silver material may be applied to one side surface of the filter body 10 facing the relevant PCB 40 and easily block the penetration of an external signal into the filter body 10.

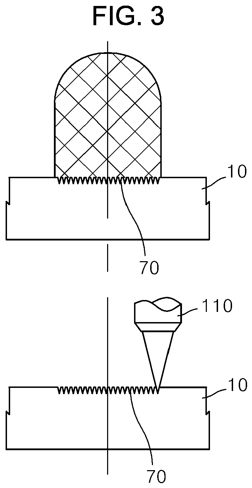

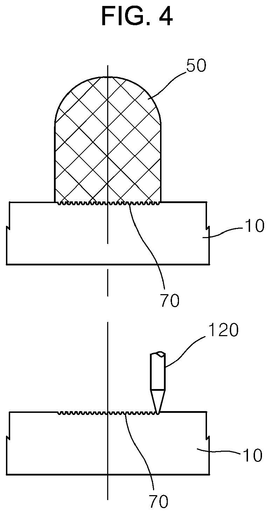

FIG. 3 is a partially enlarged view of FIG. 1 and a cross-sectional view illustrating a method of manufacturing a filter according to a first embodiment, and FIG. 4 is a partially enlarged view of FIG. 1 and a cross-sectional view illustrating a method of manufacturing a filter according to a second embodiment.

In the embodiment of the filter and the method of manufacturing the same according to the present invention, as illustrated in FIG. 3, the concave-convex portion 70 may be processed and formed by the laser processing machine 110.

In the laser processing machine 110, a non-illustrated laser generator may emit laser beams, and a width and depth of the concave portion 71 of the concave-convex portion 70 with respect to one side surface of the filter body 10 may be finely adjusted in accordance with sizes (beam widths) and focal point positions of the emitted laser beams.

In addition, the laser processing machine 110 may emit and move the laser beams to form the pre-designed concave-convex portion 70, thereby providing an advantage of very quickly and precisely processing the concave-convex portion 70.

In particular, in case that the filter body 10 is one component of a cavity filter made of a predetermined dielectric material, almost no physical force is applied to the filter body 10, which provides an advantage of preventing the filter body 10 from being cracked and broken in comparison with the case in which the concave-convex portion 70 is formed by physical stamping by the stamping tool 120 to be described below.

In addition, in the embodiment of the filter and the method of manufacturing the same according to the present invention, as illustrated in FIG. 4, the concave-convex portion 70 may be processed and formed by the stamping tool 120.

In general, the cavity filter includes the filter body 10 made of a predetermined dielectric material, and the concave-convex portion 70 may be easily formed by a predetermined stamping force applied by the stamping tool 120 during the process of manufacturing the filter body 10 by molding.

The stamping tool 120 performs stamping on one surface of the filter body 10 while being moved at a predetermined speed by a non-illustrated stamping driver, which makes it possible to very quickly process the annular concave-convex portion 70 on one surface of the filter body 10 to which the gasket 50 is attached.

Referring to FIGS. 3 and 4, the configuration in which the laser processing machine 110 is used to form the concave-convex portion 70 may further in contact with the contact area per unit area because the configuration may form the concave portion 71 having a cross-section having a pointy shape in comparison with the case in which the stamping tool 120 is used to form the concave-convex portion 70.

After the concave-convex portion 70 is formed on one side surface of the filter body 10 by the laser processing machine 110 or the stamping tool 120, a rubber material (molding resin) for forming the gasket 50 may be applied and dispensed onto one side surface of the filter body 10.

Meanwhile, before the concave-convex portion 70 is processed by the laser processing machine 110 or the stamping tool 120, one side surface of the filter body 10 may be plated with silver with a predetermined thickness. Therefore, as described above, the concave-convex portion 70 may be defined as a portion formed by emitting laser beams to or being stamped on one side surface of the filter body 10 plated with silver.

In this case, a thickness of the concave-convex portion 70 may be smaller than a thickness of the gasket 50 applied by the dispensing process S30 to be described below. Because the gasket 50 is applied to cover the entire concave-convex portion 70, the concave-convex portion 70, which does not have a smooth surface, from being exposed to the impedance matching space 20 and breaking the impedance matching.

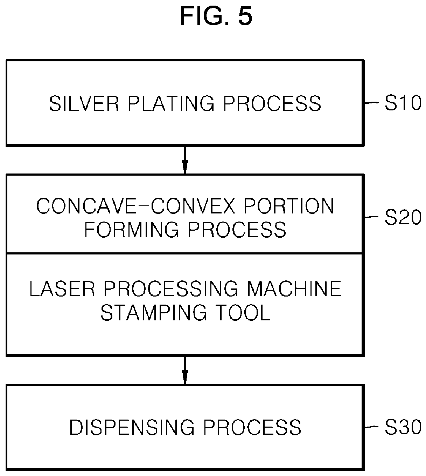

FIG. 5 is a flowchart illustrating a sequence of the method of manufacturing a filter according to the embodiment of the present invention.

The method of manufacturing the filter according to the embodiment of the present invention configured as described above will be briefly described.

As illustrated in FIGS. 1 to 4 and 5, the method of manufacturing a filter according to the embodiment of the present invention includes: a filter body manufacturing process (no reference numeral) of preparing the filter body 10 made of a predetermined dielectric material and having at least one cavity; and a concave-convex portion forming process S20 of processing and forming the concave-convex portion 70 on a portion of the filter body 10 to which the annular gasket 50 is attached between the filter body 10 and the relevant PCB 40 coupled to be in close contact with one side of the filter body 10.

In the embodiment of the present invention, the filter body 10 is adopted as one component of the cavity filter, but the present invention is not necessarily limited to the filter body 10 of the cavity filter. It can be said that the filter body 10 with any material or any specifications may be included in the protection scope of the present invention as long as the gasket 50, which is made of a material different from a material of the filter body 10, is applied by the dispensing process S30 to be described below in the configuration for preventing a signal leak (blocking a signal). That is, in addition to the cavity filter, a waveguide filter made of a ceramic material may be adopted as the filter body 10.

In this case, the concave-convex portion forming process S20 may be defined as a process of forming the annular concave-convex portion 70 on an outer rim portion of the impedance matching space 20 penetratively formed in the filter body 10 toward one side surface.

However, in the method of manufacturing a filter according to the embodiment of the present invention, the concave-convex portion 70 is limited as being formed in an annular shape corresponding to a shape of a circular hole (no reference numeral) of one surface of the filter body 10 opened at one side. However, the shape of the concave-convex portion 70 need not be necessarily limited to the annular shape. The concave-convex portion 70 may be formed in any shape within a range in which the concave-convex portion 70 may block a signal.

In addition, as illustrated in FIG. 3, the concave-convex portion forming process S20 may be defined as a process of processing and forming the concave-convex portion 70 by the laser processing machine 110.

Further, as illustrated in FIG. 4, the concave-convex portion forming process S20 may be defined as a process of processing and forming the concave-convex portion 70 by the stamping tool 120.

However, the method may further include a silver plating process S10 of plating one side surface of the filter body 10, on which the concave-convex portion 70 is to be formed, with silver before the concave-convex portion forming process S20. Further, the method may further include a dispensing process S30 of dispensing and applying resin, i.e., a molding material for the gasket 50 on one side surface of the filter body 10 after the concave-convex portion forming process S20.

In case that the molding material for the gasket 50 is applied onto the concave-convex portion 70 by the dispensing process S30, the resin is cured while penetrating into the concave-convex portion 70 formed on the filter body 10 or an outer surface of the silver plating layer to increase a surface area, such that a joining force (tensile force) increases further in comparison with a case in which the resin is applied onto a non-processed surface.

In this case, as illustrated in FIGS. 3 and 4, in the dispensing process S30, an application thickness of the gasket 50 may be set to be larger than a thickness of the concave-convex portion 70. The gasket 50 applied by the dispensing process S30 covers the entire concave-convex portion 70, which makes it possible to prevent the concave-convex portion 70 from being exposed to the impedance matching space 20 that requires impedance matching.

In addition, the resin, i.e., the molding material for the gasket 50 applied by the dispensing process S30 penetrates into the concave portion 71 of the concave-convex portion 70. After the molding material is cured, the molding material may have a viscosity to a degree to which the molding material has a predetermined thickness from one side surface of the filter body 10 on which the concave-convex portion 70 is formed. In this case, the predetermined thickness may be defined as a thickness of the molding material being in close contact with an opposing surface of the relevant PCB 40 at least being in close contact with one side surface of the filter body 10.

According to the filter and the method of manufacturing the same according to the present invention configured as described above, the trivalent chromate plating process may be eliminated. Therefore, it is possible to reduce a risk of environmental pollution, decrease unit manufacturing price of the product, and significantly reduce the time required to process the product.

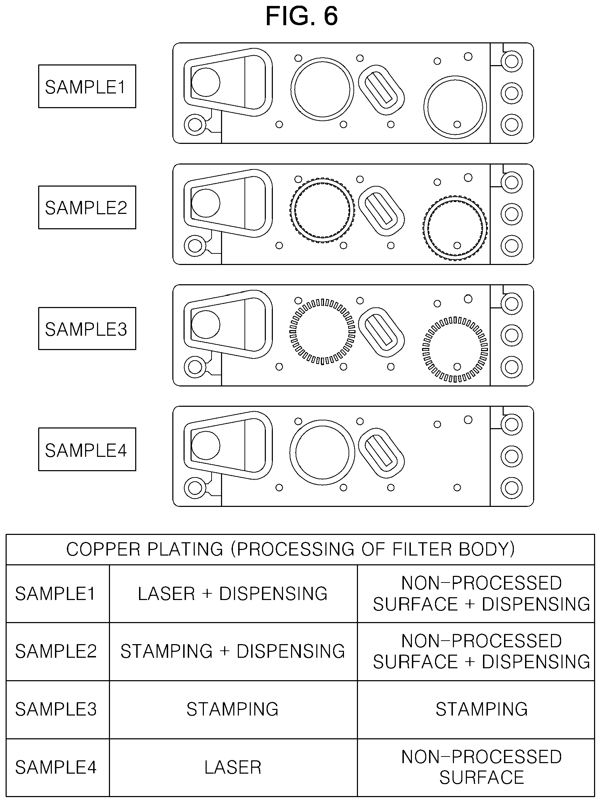

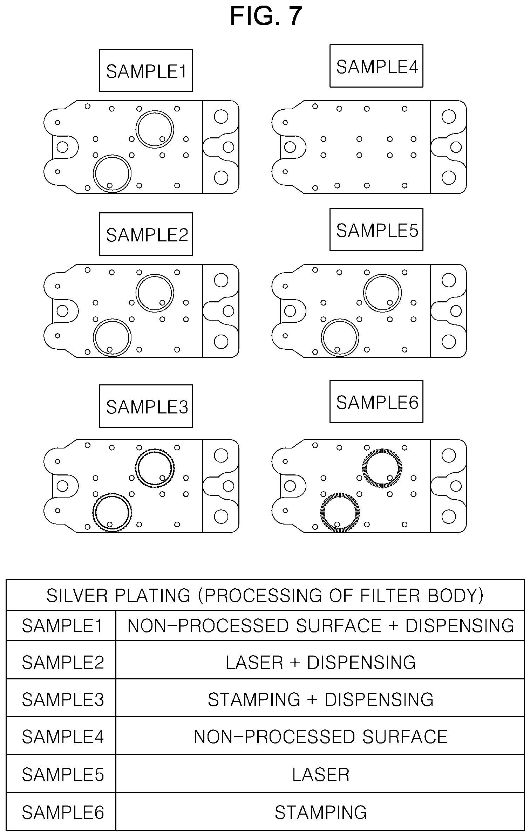

FIGS. 6 and 7 are views illustrating samples manufactured by the laser processing machine and the stamping tool.

According to the processing sequence, the concave-convex portion 70 is formed on a raw material of the filter body 10 by the laser processing machine 110 or the stamping tool 120, and then the dispensing process is performed, such that the samples illustrated in the attached FIGS. 6 and 7 may be obtained.

For reference, FIG. 6 illustrates samples manufactured by a copper plating process instead of a silver plating process, and FIG. 7 illustrates samples manufactured by a silver plating process.

Referring to FIGS. 6 and 7, it can be ascertained that in case that the concave-convex portion 70 is formed by the laser processing machine 110, the concave portion 71 and the convex portion 72 may be more precisely processed, and the processing density of the concave-convex portion 70 is high in comparison with the case in which the concave-convex portion 70 is formed by the stamping tool 120.

In addition, according to a result of comparing the case in which a silver plating layer is provided by adding a silver plating process (see FIG. 7) and the case in which a copper plating layer is provided by adding a copper plating process (see FIG. 6) with the naked eye, it can be ascertained that there is only a difference in plating materials indicating external appearance colors without a difference in terms of the processing density of the concave-convex portion 70.

As described above, according to the filter and the method of manufacturing the same according to the embodiment of the present invention, the concave-convex portion 70 is formed in advance on one side surface of the filter body 10 or the surface of the plating layer by the laser processing machine 110 or the stamping tool 120 during the process of applying and forming the gasket 50 made of rubber, which is different from a material of the filter body 10, directly on the surface of the dielectric material, i.e., the inherent material of the filter body 10 or the surface of the material for forming the plating layer formed by performing the plating process on one side surface of the filter body 10. Therefore, it is possible to further improve a joining force (tensile force) against the filter body 10 and improve the reliability of the product.

In addition, the trivalent chromate plating process, which is performed in the related art, is completely eliminated to improve the joining force (tensile force), which makes it possible to additionally obtain advantages of reducing costs and preventing environmental pollution.

The embodiments of the filter and the method of manufacturing the same according to the present invention have been described above in detail with reference to the accompanying drawings. However, the present invention is not necessarily limited by the embodiments, and various modifications of the embodiments and any other embodiments equivalent thereto may of course be carried out by those skilled in the art to which the present invention pertains. Accordingly, the true protection scope of the present invention should be determined by the appended claims.

### [Industrial Applicability]

The present invention provides the filter manufactured by eliminating the trivalent chromate plating process and by performing surface processing only on the local portion to which the gasket is joined to directly increase a physical tensile force between the gasket and the filter or by performing the surface processing after performing the silver plating process only on the local portion to which the gasket is joined, instead of the trivalent chromate plating process in the related art, and the method of manufacturing the same.

## Claims

1. A filter comprising:
an RF connector configured to have a predetermined electrical signal line;
a filter body having at least one impedance matching space in which the RF connector is installed;
a relevant PCB on which one end of the RF connector is fixedly mounted, the relevant PCB coupled to be in close contact with one side surface of the filter body; and
an annular gasket interposed between one side surface of the filter body and the relevant PCB to block a signal leak,
wherein a concave-convex portion is processed on a surface of one side surface of the filter body to which the annular gasket is attached to increase an attachment area.

2. The filter of claim 1, wherein the gasket is made of rubber.

3. The filter of claim 1, wherein the concave-convex portion is processed and formed by a laser processing machine.

4. The filter of claim 1, wherein the concave-convex portion is processed and formed by a stamping tool.

5. The filter of claim 3 or 4, wherein the concave-convex portion is formed on a surface of a silver plating layer formed on one side surface of the filter body by plating.

6. A method of manufacturing a filter, the method comprising:
a concave-convex portion forming process of processing and forming a concave-convex portion on one side surface of a filter body to which an annular gasket is attached between the filter body and a relevant PCB coupled to be in close contact with one side of the filter body; and
a dispensing process of dispensing and applying resin, which is a molding material for the gasket, on one side surface of the filter body after the concave-convex portion forming process.

7. The method of claim 6, wherein the concave-convex portion forming process is a process of forming the annular concave-convex portion on an outer rim portion of an impedance matching space penetratively formed in the filter body toward one side surface.

8. The method of claim 6, wherein the concave-convex portion forming process is a process of processing and forming the concave-convex portion by a laser processing machine.

9. The method of claim 6, wherein the concave-convex portion forming process is a process of processing and forming the concave-convex portion by a stamping tool.

10. The method of claim 6, further comprising:
a silver plating process of plating one side surface of the filter body, on which the concave-convex portion is formed, with silver before the concave-convex portion forming process.

11. The method of claim 6, wherein resin, which is a molding material for the gasket applied by the dispensing process, penetrates into a concave portion of the concave-convex portion, and after the resin is cured, the resin has a viscosity to a degree to which the resin has a predetermined thickness from one side surface of the filter body on which the concave-convex portion is formed.

12. The method of claim 6, wherein an application thickness of the gasket during the dispensing process is set to be larger than a thickness of the concave-convex portion.
